# EUROPEAN PATENT SPECIFICATION

(11) **EP 2 993 259 B1**
(45) Date of publication and mention of the grant of the patent: **17.01.2018**
(21) Application number: 15182689.8
(22) Date of filing: 27.08.2015
(51) Int. Cl.: C30B 15/20, C30B 27/02, C30B 29/06

(54) **SILICON SINGLE CRYSTAL FABRICATION METHOD**
VERFAHREN ZUR HERSTELLUNG EINES SILICIUMEINKRISTALLS
PROCÉDÉ DE FABRICATION DE MONOCRISTAL DE SILICIUM

(30) Priority: 05.09.2014 JP 2014180777
(43) Date of publication of application: 09.03.2016
(73) Proprietor: GlobalWafers Japan Co., Ltd., Niigata 957-0197 (JP)
(72) Inventor: Nagai, Yuta, Tokyo, 141-0032 (JP); Nakagawa, Satoko, Tokyo, 141-0032 (JP); Higasa, Mitsuo, Tokyo, 141-0032 (JP); Kashima, Kazuhiko, Tokyo, 141-0032 (JP)
(74) Representative: Hoffmann Eitle

(56) References cited:
- EP-A1- 1 840 248
- EP-A1- 2 824 222
- JP-A- H 092 892
- JP-A- 2001 010 893
- NAGAI Y ET AL: "Crystal growth of MCZ silicon with ultralow carbon concentration", JOURNAL OF CRYSTAL GROWTH, ELSEVIER, AMSTERDAM, NL, vol. 401, 28 November 2013 (2013-11-28), pages 737-739, XP029040642, ISSN: 0022-0248, DOI: 10.1016/J.JCRYSGRO.2013.11.059

## Description

### BACKGROUND OF THE INVENTION

### Field of the Invention

The present invention relates to silicon single crystal fabrication methods and, more particularly, relates to silicon single crystal fabrication methods adapted to fabricate silicon single crystals by Czochralski (hereinafter, abbreviated as CZ) method.

### Description of the Related Art

As silicon single crystal ingot fabrication methods, there are CZ methods and FZ (Floating Zone) methods. Silicon single crystals fabricated by FZ methods (hereinafter, abbreviated as FZ silicon crystals) have significantly-lower oxygen concentrations and, thus, growth of oxygen-precipitation nuclei therein is suppressed. Therefore, conventionally, FZ silicon crystals have been used for IGBT silicon substrates.

On the other hand, in CZ methods, a raw material is charged into a quartz crucible, which causes a significantly-larger amount of oxygen from the quartz crucible to mix therein, thereby making it difficult to lower the oxygen concentration to an equivalent level to that of FZ silicon crystals. This facilitates growth of oxygen-precipitation nuclei, which form carrier recombination centers, thereby shortening the carrier lifetimes. Therefore, CZ methods have been unsuitable for IGBT silicon substrates intended for higher withstand voltages.

However, formation of oxygen-precipitation nuclei in silicon single crystals is mainly caused by carbon impurities, and the growth of oxygen-precipitation nuclei formed therein is influenced by the oxygen concentrations of the crystals. Accordingly, in order to use CZ silicon crystals for IGBTs, there is a need for reducing the carbon concentrations of the crystals to 1.0×10¹⁴ atoms/cm³ or less for suppressing the formation itself of oxygen-precipitation nuclei, since there is a limit to the reduction of the oxygen concentrations therein.

It can be considered that the carbon concentration of a crystal can be reduced by reducing the carbon concentration of the raw material. However, due to the influence of segregation, the carbon concentration increases as the pull up of the silicon single crystal is carried forward, which makes it difficult to suppress the carbon concentration to 1.0×10¹⁴ atoms/cm³ or less over the entire length of the crystal. Further, it takes a significantly-higher cost to provide a raw material with such a lower carbon concentration.

On the other hand, it has been known that the carbon concentration of a crystal can be reduced by controlling the speed of contamination (the amount of mixture) of CO mixed into the melt from the high-temperature carbon members such as the heater and the graphite crucible in the furnace, and by controlling the speed of vaporization (the amount of vaporization) of CO from the melt. Further, the generation of CO from the aforementioned high-temperature carbon members is caused by the reaction of SiO vaporized from the melt as follows: SiO(gas)+2C(solid)→CO(gas)+SiC(solid)

Namely, the carbon concentration of a silicon single crystal can be reduced by lowering, as much as possible, the amount of mixture of CO mixed into the melt from the high-temperature carbon members such as the heater and the graphite crucible in the furnace, while heightening, as much as possible, the amount of vaporization of CO from the melt.

On the other hand, as conventional semiconductor single crystal fabrication equipment using CZ methods, there have been suggested semiconductor single crystal fabrication equipment which are provided with an exhaust flow path formed by an inner tube and an outer tube as described in JP 7-223894 A, and, also, there have been suggested semiconductor single crystal fabrication equipment which are provided with exhaust pipes as described in JP 2006-169010 A, in order to prevent SiO from coming into contact with a graphite crucible and a heater for preventing the formation of SiC in the graphite crucible and the heater, in exhausting SiO and CO generated in a furnace to the outside of the furnace, although these equipment are not intended to reduce the carbon concentrations of silicon single crystals.

At first, the semiconductor single crystal fabrication device described in JP 7-223894 A will be described with reference to FIG. 8. As illustrated in FIG. 8, the semiconductor single crystal fabrication device 20 includes a crucible 21 for melting a raw material for a silicon single crystal, a heater 22 which exists around the crucible 21 for heating the raw material in the crucible, a radiant screen 23 which is provided above the crucible 21 and surrounds a single crystal pull-up area for insulating heat, and a pull-up mechanism (not illustrated) for immersing a seed crystal P in the molten raw material and for pulling up the single crystal C.

Further, an inner tube 24 is provided in the proximity of the outer peripheral surface of the heater 22 and, also, an outer tube 25 is provided in such a way as to surround the heater 22, such that a purging inert gas introduced into a chamber 20a through its upper portion flows thereinto through the radiant screen 23, further flows downward through the gap between the inner tube 24 and the outer tube 25 and is exhausted therefrom through a bottom portion 20b of the chamber 20a. Further, a heat-insulating tube 26 is placed on the outer peripheral surface of the outer tube 25.

However, in the semiconductor single crystal fabrication device 20 described in JP 7-223894 A, heat generated from the heater 22 is intercepted by the inner tube 24 and, thus, the outer tube 25 is significantly lowered in temperature, which causes SiO generated in the furnace to adhere and condense to and on the outer tube 25, thereby causing the detriment of clogging of the exhaust flow path between the inner tube 24 and the outer tube 25, due to deposition of SiO.

In order to overcome this, there has been suggested the semiconductor single crystal fabrication device in JP 2006-169010 A. The semiconductor single crystal fabrication device described in JP 2006-169010 A will be described with reference to FIGS. 9A and 9B. As illustrated in FIGS. 9A and 9B, the semiconductor single crystal fabrication device 30 is provided with plural exhaust pipes 32, along the peripheral direction of the heater 31, outside the heater 31. These exhaust pipes 32 are secured to an exhaust-pipe securing ring 33 with an annular plate shape which is formed in such a way as to cover the upper end of the heater 31.

Further, the exhaust-pipe securing ring 33 is secured at its outer periphery to the outer tube 34, and a crucible 35 is placed in a hole at the center of the exhaust-pipe securing ring 33. The crucible 35 is constituted by a graphite crucible 35a and a quartz crucible 35b.

Further, there is provided a radiant screen 37 which is provided above the crucible 35 and surrounds the single crystal pull-up area for insulating heat and, further, there is provided a lid plate 38 which is mounted at its outer peripheral portion to the outer tube 34, while the radiant screen 37 is mounted to the inner peripheral portion of the lid plate 38. Further, a heat insulator 39 is placed on the outer peripheral surface of the outer tube 34.

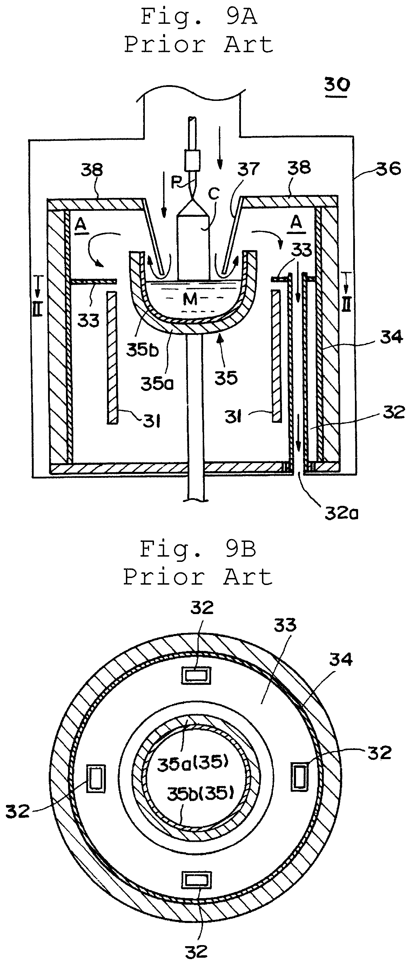

Further, during pulling up of the single crystal, an inert gas (Ar gas) is introduced into the chamber 36 through the upper portion of the chamber 36, and the aforementioned inert gas flows downward to the outer peripheral surface of the single crystal C and passes through the gap between the melt M and the lower end of the radiant screen 37, as indicated by arrows in FIGS. 9A. Thereafter, it ascends along the inner surface of the quartz crucible 35b, then is introduced into a space A surrounded by the lid plate 38, the exhaust-pipe securing ring 33 and the outer tube 34, further, flows downward through the exhaust pipes 32 and is exhausted to the outside of the chamber 36 through exhaust ports 32a.

On the other hand, as described above, in order to lower the carbon concentration of the silicon single crystal, it is necessary to lower, as much as possible, the amount of mixture of CO mixed into the melt from the high-temperature carbon members such as the heater and the graphite crucible and, more specifically, it is necessary to inhibit SiO generated in the furnace from coming into contact with the graphite crucible and the heater and, also, it is necessary to inhibit back diffusion, which is return of CO generated from the graphite crucible and the heater to the melt, due to the influences of advections and diffusions thereof due to the purging inert gas.

On the other hand, the equipment described in JP 7-223894 A and JP 2006-169010 A are adapted to prevent SiO from coming into contact with the graphite crucible and the heater for preventing the formation of SiC in the graphite crucible and the heater, in exhausting SiO and CO generated in the furnace to the outside the furnace. Thus, no consideration has been given to back diffusion, which is return of CO generated from the graphite crucible and the heater to the melt, due to the influences of advections and diffusions thereof due to the inert gas.

Particularly, the device described in JP 7-223894 A has induced the detriment of clogging of the exhaust flow path between the inner tube and the outer tube, due to deposition, since SiO generated in the furnace adheres and condenses to and on the outer tube. Therefore, there has been the technical problem that it is unsuitable as a lower-carbon silicon single crystal fabrication device.

Further, the equipment described in JP 2006-169010 A is adapted to introduce SiO and CO generated in the furnace into the space surrounded by the lid plate, the exhaust-pipe securing ring and the outer tube and, further, is adapted to flow them downward through the exhaust pipes having a smaller conductance than that of the space. This has made it impossible to suppress back diffusion of SiO and CO generated in the furnace, which is return of such SiO and CO, stagnating in the space surrounded by the lid plate, the exhaust-pipe securing ring and the outer tube and return of such SiO and CO to the melt. Therefore, there has been the technical problem that it is unsuitable as a lower-carbon silicon single crystal fabrication device.

The present inventors have focused attention to control of CO mixed into the melt from the heater and the graphite crucible in the furnace, in order to lower the carbon concentrations of crystals.

More specifically, the present inventors have earnestly made studies, in focusing attention to inhibiting SiO generated in the furnace from coming into contact with the heater and the graphite crucible for reducing CO generated from the heater and the graphite crucible, and in focusing attention to suppressing back diffusion, which is return of CO generated from the heater and the graphite crucible to the melt.

In these studies, they have made studies of optimum silicon single crystal fabrication methods, on the premise of equipment adapted to perform exhaust through an exhaust flow path between an inner tube and an outer tube, as the device described in JP 7-223894 A, since, in cases of performing exhaust using exhaust pipes from a space surrounded by a lid plate, an exhaust-pipe securing ring and an outer tube as in the device described in JP 2006-169010 A, it is difficult to suppress back diffusion of SiO and CO generated in the furnace, which is return of such SiO and CO to the melt, stagnating in the aforementioned space.

Further, they have attained the present invention by finding the fact that SiO generated in the chamber can be inhibited from coming into contact with the graphite crucible and the heater and, further, the amount of mixture of CO, generated on and coming from the graphite crucible and the heater, mixed into the melt, can be reduced, by causing the exhaust cross-sectional areas of a single certain exhaust flow path to fall within a certain range during melting of the raw material and during pulling up of the single crystal, and by causing the exhaust cross-sectional area of another certain exhaust flow path to fall within a certain range until the completion of the pull up of the single crystal since when the raw material has been molten.

Y. Nagai et al. "Crystal growth of MCZ silicon with ultralow carbon concentration", Journal of Crystal Growth 401 (2014), 737-739 is further prior art. EP 2 824 222 A1 is prior art under Art. 54(3) EPC for novelty only.

### SUMMARY THE INVENTION

The present invention has been made in order to overcome the aforementioned technical problem, and an object thereof is to provide a silicon single crystal fabrication method which is capable of inhibiting SiO generated in a chamber from coming into contact with a graphite crucible and a heater and, also, are capable of suppressing back diffusion of CO generated from the graphite crucible and the heater, which is return of such CO to the melt and a silicon single crystal.

A silicon single crystal fabrication method according to the present invention, which has been made for overcoming the aforementioned technical problem, is a silicon single crystal fabrication method using a silicon single crystal fabrication device, the silicon single crystal fabrication device including a cylindrical-shaped chamber having a supply port for supplying an inert gas thereto, a crucible provided in the chamber, the crucible being constituted by a quartz-glass crucible at its inner side and a graphite crucible at its outer side, an ascend/descend portion configured to ascend/descend a height of the crucible, a control portion configured to control the ascend/descend portion, a carbon heater for melting a raw-material silicon charged in the crucible, an inner tube provided around an outer periphery of the carbon heater, an outer tube provided around an outer periphery of the inner tube, a first heat-reserving plate extending inward at an upper end portion of the inner tube, a second heat-reserving plate extending inward at an upper end portion of the outer tube, a radiant shield which is provided above and near the crucible and is provided, at its upper and lower portions, with an opening surrounding a periphery of a silicon single crystal, and an exhaust flow path formed by a first exhaust flow path formed by the radiant shield and an inner peripheral surface of the crucible, a second exhaust flow path formed by the first heat-reserving plate and the second heat-reserving plate, and a third exhaust flow path formed by the inner tube and the outer tube, wherein a position of an upper end of the graphite crucible is controlled to be equal to or more than 5 mm but equal to or less than 95 mm above an upper end of the heater, during melting of the raw material before start of pulling up of the silicon single crystal, and a position of the crucible is controlled, such that an exhaust cross-sectional area of a gap between a lower end of the radiant shield and a surface of the melt, in the first exhaust flow path, is smaller than an exhaust cross-sectional area of the third exhaust flow path formed by the inner tube and the outer tube, until completion of pulling up of the silicon single crystal since completion of the melting of the raw material.

As described above, during melting of the raw material before the start of pulling up of the silicon single crystal, the position of the upper end of the graphite crucible is controlled to be equal to or more than 5 mm but equal to or less than 95 mm above the upper end of the heater. Namely, the upper end portion of the crucible has a function of shielding against flows of the inert gas, which inhibits SiO generated in the chamber from coming into contact with the graphite crucible and the heater, thereby suppressing the generation of CO. Further, due to the shielding function of the upper end portion of the crucible, it is possible to suppress back diffusion of CO generated from the graphite crucible and the heater, which is return of such CO to the melt.

Further, the position of the crucible is controlled, such that the exhaust cross-sectional area of the gap between the lower end of the radiant shield and the surface of the melt, in the first exhaust flow path, is smaller than the exhaust cross-sectional area of the third exhaust flow path formed by the inner tube and the outer tube, until the completion of pulling up of the silicon single crystal since the completion of the melting of the raw material.

Since the exhaust cross-sectional area of the gap between the lower end of the radiant shield and the surface of the melt is made smaller, it is possible to make flow velocities at the surface of the melt higher, thereby increasing the amount of CO vaporized from the melt. Further, since the exhaust cross-sectional area of the third exhaust flow path formed by the inner tube and the outer tube is made larger, it is possible to increase the conductance of the third exhaust flow path, which can realize smooth exhaust flows and can suppress clogging thereof.

Since the position of the crucible is controlled, such that the exhaust cross-sectional area of the gap between the lower end of the radiant shield and the surface of the melt is smaller than the exhaust cross-sectional area of the third exhaust flow path, until the completion of pulling up of the silicon single crystal since the completion of the melting of the raw material, as described above, it is possible to increase the amount of CO vaporized from the melt and, further, it is possible to suppress back diffusion of CO generated from the graphite crucible and the heater. This enables fabrication of a silicon single crystal with a lower carbon concentration.

In this case, it is preferable that, until the completion of pulling up of the single crystal since the start of the pulling up of the silicon single crystal, the position of the upper end of the graphite crucible is controlled, such that the smallest cross-sectional area, out of the cross-sectional area of the flow path formed by the radiant shield and the upper end of the graphite crucible, has an area equal to or larger than the cross-sectional area of the gap between the lower end of the radiant shield and the surface of the melt.

If the exhaust cross-sectional area of the flow path between the radiant shield 11 and the graphite crucible upper end is smaller than the cross-sectional area of the inlet of the first exhaust flow path, the conductance of the flow path between the radiant shield and the graphite crucible upper end is made smaller, which makes the exhaust resistance larger. This causes the detriment that back diffusion, which is return of CO generated from the graphite crucible and the heater to the melt, cannot be suppressed, since such CO is influenced by advections and diffusions due to the inert gas, which is not preferable.

Further, it is desirable that the exhaust cross-sectional area of the second exhaust flow path formed by the first heat-reserving plate and the second heat-reserving plate is made larger than the exhaust cross-sectional area of the third exhaust flow path formed by the inner tube and the outer tube.

Since the exhaust cross-sectional area of the second exhaust flow path is made larger than the exhaust cross-sectional area of the third exhaust flow path, as described above, it is possible to smoothly exhaust SiO and CO. Further, this can prevent SiO from being adhered to the radiant shield and the second heat-reserving plate, which results in suppression of dislocation of the crystal.

Further, it is desirable that a heat insulator is provided on the outer periphery of the outer tube, and the inner tube is formed to be a double tube, and a heat insulator is provided in a space between the tubes of the double tube.

Since the heat insulator is provided on the outer periphery of the outer tube, and the inner tube is formed to be a double tube, and the heat insulator is provided in the space between the tubes of the double tube, as described above, it is possible to reduce the electric output of the heater.

On the other hand, the heat insulator in the space between the tubes of the double tube is for alleviating heat dissipation. By adjusting the wall thickness of the heat insulators in the space between the tubes of the double tube and on the outer tube, it is possible to maintain the temperature of the third exhaust flow path at a predetermined temperature or higher, which can suppress clogging thereof due to SiO deposition.

Further, by fabricating a silicon single crystal by the aforementioned silicon single crystal fabrication method, it is possible to provide a silicon single crystal with a lower carbon concentration.

According to the present invention, it is possible to provide a silicon single crystal fabrication method which is capable of inhibiting SiO generated in the chamber from coming into contact with the graphite crucible and the heater and, further, is capable of suppressing back diffusion, which is return of CO generated from the graphite crucible and the heater to the melt. Further, it is possible to provide a silicon single crystal with a lower carbon concentration, by the aforementioned silicon single crystal fabrication method.

### BRIEF DESCRIPTION OF THE DRAWINGS

FIG. 1 is a schematic cross-sectional view of a silicon single crystal fabrication device for implementing the present invention;
FIG. 2 is an I-I cross-sectional view of the silicon single crystal fabrication device illustrated in FIG. 1;
FIG. 3 is a main-part cross-sectional view of the silicon single crystal fabrication device illustrated in FIG. 1;
FIG. 4 is a main-part cross-sectional view of the silicon single crystal fabrication device illustrated in FIG. 1;
FIG. 5 is a graph illustrating the carbon concentrations of silicon single crystals according to Examples 1, 2 and 3;
FIG. 6 is a graph illustrating the carbon concentrations of silicon single crystals according to Examples 2, 4, 5 and 6;
FIG. 7 is a graph illustrating the carbon concentrations of silicon single crystals according to Comparative Examples 1, 3 and 4;

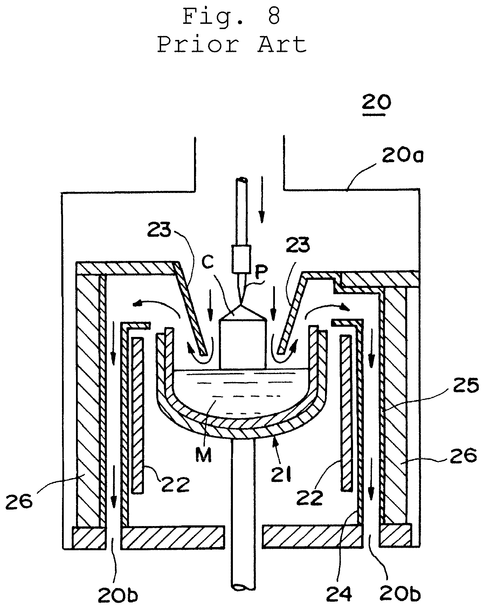

FIG. 8 is a schematic cross-sectional view of a conventional silicon single crystal fabrication device; and
FIGS. 9A and 9B are views of another conventional silicon single crystal fabrication device, wherein FIG. 9A is a schematic cross-sectional view, and FIG. 9B is a cross-sectional view taken along II-II in FIG. 9A.

### DESCRIPTION OF THE PREFERRED EMBODIMENTS

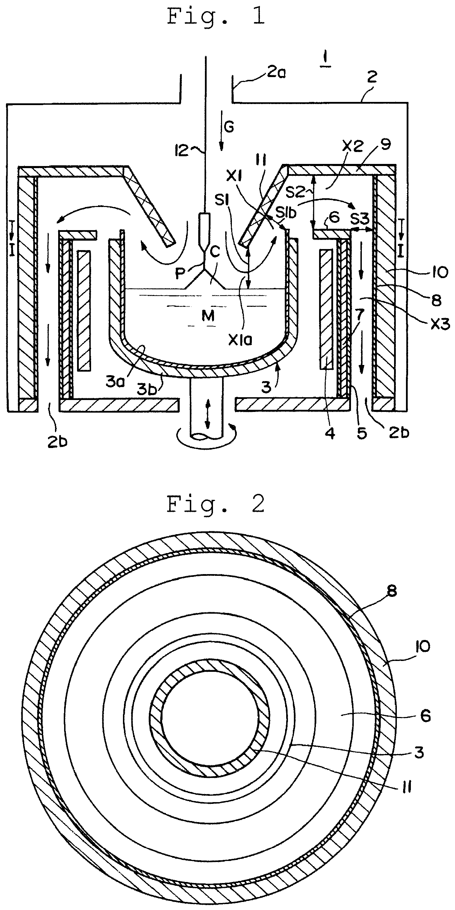

Hereinafter, a silicon single crystal fabrication device for use in the present invention will be described with reference to FIGS. 1 to 4.

The fabrication device 1 includes a chamber (furnace body) 2 with a cylindrical shape, a crucible 3 provided in the chamber 2, and a carbon heater 4 for melting a raw-material silicon charged in the crucible 3. Further, the crucible 3 is constituted by a quartz-glass crucible 3a in its inner side, and a graphite crucible 3b in its outer side. Further, the fabrication device 1 is a fabrication device configured to utilize an MCZ method (Magnetic field applied CZ method) for applying a lateral magnetic field to the melt. The means used therein for applying the lateral magnetic field is well-known means and, therefore, is not illustrated in the figure.

Further, in the chamber 2, an inner tube 5 is provided around the outer periphery of the carbon heater 4. The inner tube 5 is formed into a cylindrical shape, and a first heat-reserving plate 6 extending inward is provided on the upper end portion thereof. Further, the inner tube 5 is formed to be a double tube, and a heat-insulating material 7 is provided in the space between the tubes of the double tube.

Further, the inner tube 5 and the first heat-reserving plate 6 are placed in such a way as to cover the outer peripheral surface and the upper surface of the carbon heater 4. Since the carbon heater 4 is covered therewith over its outer peripheral surface and its upper surface as described above, when SiO and CO generated in the chamber 2 are exhausted to the outside of the furnace, SiO is inhibited from coming into contact with the heater 4.

Further, in the chamber 2, an outer tube 8 is provided around the outer periphery of the inner tube 5. The outer tube 8 is formed into a cylindrical shape, and a second heat-reserving plate 9 extending inward is provided on its upper end portion. A second exhaust flow path X2 is formed between the first heat-reserving plate 6 and the second heat-reserving plate 9, and a third exhaust flow path X3 is formed between the inner tube 5 and the outer tube 8. A heat insulator 10 is provided on the outer periphery of the aforementioned outer tube 8.

The heat insulator 7 is for suppressing heat dissipation from the inner tube 5, and the heat insulator 10 is for suppressing heat dissipation from the outer tube 8, which enables maintaining the third exhaust flow path X3 at a predetermined temperature, thereby enabling reduction of the output of the carbon heater 4.

Further, if the wall thickness (the thickwise size in the radial direction) of the heat insulator 7 is made larger, this may lower the temperature of the third exhaust flow path X3 formed between the inner tube 5 and the outer tube 8. Therefore, the heat insulator 7 is formed to be thinner, in comparison with the wall thickness (the thickwise size in the radial direction) of the heat insulator 10. It is desirable that the wall thicknesses of the heat insulators 7 and 10 are set to be thicknesses which enable maintaining the temperature of the third exhaust flow path X3 at 1300 K or more. By maintaining the temperature of the third exhaust flow path X3 at 1300 K or more, it is possible to suppress clogging thereof due to SiO.

Further, at the inner peripheral end of the second heat-reserving plate 9, there is provided a radiant shield 11 for preventing extra radiant heat from the carbon heater 4 and the like from being applied to the single crystal C being grown.

The radiant shield 11 is provided, at its upper and lower portions, with an opening surrounding the periphery of the single crystal C, above and near the crucible 3. Further, the radiant shield 11 is provided with a tapered surface, such that the area of the opening gradually decreases with increasing distance from its upper portion toward the lower portion.

Due to the provision of this radiant shield 11, a purging inert gas (Ar gas) G supplied to the inside of the crucible 3 from thereabove passes through the gap between the radiant shield 11 and the melt M (the first exhaust flow path X1), then is flowed along the flow paths indicated by arrows in FIG. 1 and, then, is exhausted to the outside of the crucible.

Further, although not illustrated, above the chamber 2, there is provided a pull-up mechanism for pulling up the single crystal C. This pull-up mechanism is constituted by a winding-up mechanism which is driven by a motor, and a pull-up wire 12 which is wound up by this winding-up mechanism. Further, the wire 12 is adapted such that a seed crystal P is mounted to the tip end thereof and, further, the wire 12 is configured to pull up the single crystal C being grown. Further, the silicon single crystal fabrication device 1 includes a motor for rotating the crucible 3, an ascend/descend device for controlling the height of the crucible 3, the aforementioned motor, and a control device for controlling the aforementioned ascend/descend device. Thus, the silicon single crystal fabrication device 1 is configured to grow the single crystal C while rotating the crucible 3 and ascending the height of the crucible 3.

Further, the chamber 2 is provided with a gas supply port 2a at its upper portion, so that Ar gas as an inert gas is supplied to the inside of the chamber 2. Further, the chamber 2 is provided with plural exhaust ports 2b in its bottom portion, and an exhaust pump (not illustrated) as exhaust means is connected to these exhaust ports 2b.

Accordingly, the Ar gas G supplied to the inside of the chamber 2 through the gas supply port 2a passes through the first exhaust flow path X1, the second exhaust flow path X2, and the third exhaust flow path X3 and, further, is exhausted to the outside, through the exhaust pump.

Next, there will be described, in detail, the exhaust flow path constituted by the first exhaust flow path X1, the second exhaust flow path X2 and the third exhaust flow path X3.

As illustrated in FIG. 1, the gap (the inlet portion) X1a between the lower end of the radiant shield 11 and the surface of the melt M, which corresponds to the inlet of the first exhaust flow path X1, is formed around the entire periphery of the crucible 3. Since the aforementioned inlet portion X1a is formed around the entire periphery of the crucible 3 as described above, CO vaporized from the surface of the melt M can be exhausted without stagnating in the furnace.

Further, assuming that the cross-sectional area (the exhaust cross-sectional area orthogonal to gas flows) of the gap (the inlet portion) X1a between the lower end of the radiant shield 11 and the surface of the melt M and is S1, as the exhaust cross-sectional area S1 is made smaller, the flow velocity of the Ar gas G in the radially-outward direction of the crucible 3 is increased, which can increase the amount of CO vaporized from the surface of the melt M and, further, can suppress back diffusion, which is return of CO generated from the graphite crucible 3b and the carbon heater 4 toward the melt M due to the influences of advections and diffusions thereof due to the Ar gas.

On the other hand, if the exhaust cross-sectional area S1 is excessively smaller, this may induce fluctuations at the surface of the melt and, further, may cause the surface of the melt to come into contact with the radiant shield 11, which is not preferable.

Generally, in the silicon single crystal fabrication device, the internal pressure in the chamber 2 is set to be equal to or more than 1333 Pa (10 Torr) but equal to or less than 13332 Pa (100 Torr), and the flow rate of the Ar gas introduced into the chamber 2 is set to be equal to or more than 50 L/min but equal to or less than 150 L/min. Therefore, it is desirable that the exhaust cross-sectional area S1 is made to be equal to or more than 2πr×Gap mm², wherein r = C_{D}×1.15, Gap: the height from the lower end of the radiant shield to the melt, r: the diameter of the opening of the radiant shield, and C_{D}: the diameter of the silicon single crystal.

Further, assuming that the cross-sectional area of the second exhaust flow path X2 formed by the first heat-reserving plate 6 and the second heat-reserving plate 9 is S2, and the cross-sectional area of the third exhaust flow path X3 formed by the inner tube 5 and the outer tube 8 is S3, and the inner diameter of the quartz crucible 3b is D, they are adapted in such a way as to satisfy the relationships of 1<S3/S1<D/30 and S3<S2.

Further, S1 is the cross-sectional area of the inlet portion X1a of the first exhaust flow path X1 formed by the lower end of the radiant shield 11 and the surface of the melt M and, therefore, is changed by controlling the ascend of the crucible, until the completion of the pulling up of the single crystal since when the melting of the raw material has been completed. On the other hand, S2, S3 and D are values which have been preliminarily set in the fabrication device.

In cases where the exhaust cross-sectional area S3 of the third exhaust flow path X3 is smaller than the exhaust cross-sectional area S1 of the first exhaust flow path X1, the third exhaust flow path X3 is made to have a larger exhaust resistance, which may induce back diffusion of SiO and CO generated in the chamber 2, which is stagnation of such SiO and CO in the second exhaust flow path X2 and return of them to the melt M. This is not preferable.

Further, since the exhaust cross-sectional area S3 of the exhaust flow path X3 is made smaller, clogging thereof may be induced. Therefore, it is preferable to hold 1<S3/S1.

Further, in cases where S3/S1 exceeds D/30, the heat insulator 10 placed on the outer peripheral surface of the outer tube 8 is made to have a smaller wall thickness and, therefore, there is a larger heat dissipation effect, which may cause SiO generated in the chamber 2 to adhere and condense to and on the outer tube 8, thereby causing clogging of the exhaust flow path X3. This is not preferable.

Accordingly, until the completion of pulling up the single crystal C while growing it since the process for melting the raw material, the ascend of the crucible is controlled, in such a way as to pull up the silicon single crystal, while maintaining a state where the exhaust cross-sectional area S1 formed by the melt surface and the lower end of the radiant shield 11 is smaller than the exhaust cross-sectional area S3.

Further, the exhaust cross-sectional area S2 of the second exhaust flow path X2 formed by the first heat-reserving plate 6 and the second heat-reserving plate 9 (the cross-sectional area between the inner peripheral end portion of the first heat-reserving plate 6 and the second heat-reserving plate 9, which is orthogonal to gas flows) is formed to be larger than the exhaust cross-sectional area S3 of the third exhaust flow path X3, thereby satisfying the relationship of S3>S2.

In this case, if the exhaust cross-sectional area S2 is smaller than the exhaust cross-sectional area S3 , this may cause the second exhaust flow path X2 to be clogged earlier than the third air-exhaust flow path X3, which is not preferable.

Further, SiO is adhered to the second heat-reserving plate 9, which is not preferable.

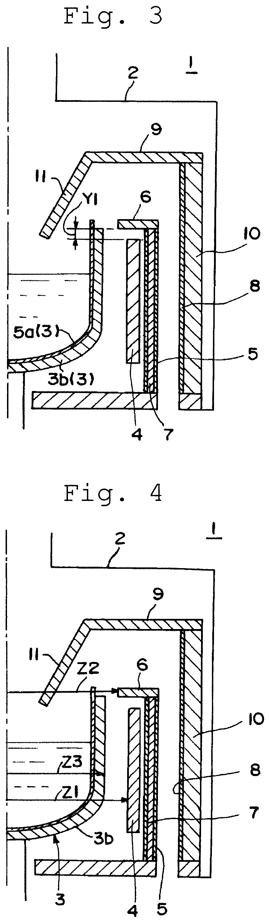

Further, as illustrated in FIG. 3, during melting of the raw material before the start of pulling up, the crucible is controlled (placed), such that the distance size Y1 between the upper end of the graphite crucible 3b and the upper end of the carbon heater 4 is equal to or more than 5 mm but equal to or less than 95 mm.

In cases where the distance size Y1 between the upper end of the graphite crucible 3b and the upper end of the carbon heater 4 is less than 5 mm (in cases where the upper end of the carbon heater 4 and the upper end of the graphite crucible 3b are at the same heightwise position or the upper end of the graphite crucible 3b is lower than the upper end of the carbon heater 4), this degrades the shielding function of the upper end portion of the crucible or causes the carbon heater 4 to be exposed to the inside of the second exhaust flow path X2.

This causes CO from the carbon heater 4 to diffuse in the second exhaust flow path X2, which may increase the amount of mixture of CO mixed into the melt from the heater 4. This is not preferable.

Further, in cases where the distance size Y1 between the upper end of the graphite crucible 3b and the upper end of the carbon heater 4 exceeds 95 mm, this lowers the temperature of the upper end of the quartz crucible 3a, which causes SiO vaporized from the melt to adhere thereto, thereby causing reduction of the yield. This is not preferable.

Further, it is preferable that the upper end of the graphite crucible 3b is controlled (placed), such that it is higher than the upper end of the first heat-reserving plate 6.

Further, it is preferable that the height of the upper end of the first heat-reserving plate 6 from the upper end of the heater 4 is equal to or more than 20 mm but equal to or less than 30 mm. If it is less than 20 mm, this may induce sparking between the heater 4 and the first heat-reserving plate 6. If it exceeds 30 mm, this may induce inflows of gas between the heater 4 and the inner tube 5. This is not preferable.

Further, until the completion of pulling up of the silicon single crystal since the start of the pulling up of the silicon single crystal, the height of the crucible (the ascend of the crucible) is controlled, such that the exhaust cross-sectional area of the flow path between the radiant shield 11 and the graphite crucible upper end (the smallest cross-sectional area out of the cross-sectional area of the flow path formed by the radiant shield 11 and the graphite crucible upper end) S1b is larger than the cross-sectional area S1 of the inlet X1a of the exhaust flow path X1. Namely, the height of the crucible (the ascending of the crucible) is controlled, in such a way as to hold the relationship of S1 ≤ S1b.

In this case, if the exhaust cross-sectional area S1b of the flow path between the radiant shield 11 and the graphite crucible upper end is smaller than the cross-sectional area S1 of the inlet X1a of the exhaust flow path X1, the conductance of the flow path between the radiant shield 11 and the graphite crucible upper end is made smaller, which makes the exhaust resistance larger, thereby causing the risk of back diffusion. This is not preferable.

Further, until the completion of pulling up of the silicon single crystal since the start of the pulling up of the silicon single crystal, the height of the crucible is controlled in such a way as to hold the relationship of S1 ≤ S1b, and the upper end of the graphite crucible 3b is placed at a position which makes the distance size Y1 from the upper end of the carbon heater 4 equal to or more than 5 mm.

The upper end of the graphite crucible (the upper portion of the crucible) functions as a shield plate, which inhibits SiO generated in the chamber from coming into contact with the graphite crucible and the heater, thereby suppressing the generation of CO.

Further, it is possible to suppress back diffusion, which is return of CO generated from the graphite crucible and the heater to the melt, since the upper end of the graphite crucible (the upper portion of the crucible) alleviates the influences of advections and diffusions thereof due to the inert gas.

Further, as illustrated in FIG. 4, there is the relationship of Z3+0. 02 × Z3 ≤ Z2 ≤ Z1, between the inner diameter Z1 of the carbon heater 4, the inner diameter Z2 of the first heat-reserving plate 6, and the outer diameter Z3 of the crucible 3 (the graphite crucible 3b).

In cases where the inner diameter Z1 of the carbon heater 4 is formed to be smaller than the inner diameter Z2 of the first heat-reserving plate 6, SiO generated in the chamber 2 is flowed toward the carbon heater 4, thereby generating CO from the carbon heater 4. This is not preferable.

Further, in cases where the inner diameter Z2 of the first heat-reserving plate 6 is smaller than Z3+0.02×Z3, the graphite crucible 3b may come into contact with the carbon heater 4, thereby causing fractures thereof, when the graphite crucible 3b is opened after the completion of pulling up thereof. This is not preferable.

Further, it is preferable that the difference between the inner diameter Z2 of the first heat-reserving plate 6 and the outer diameter Z3 of the crucible 3 (the graphite crucible 3b) is equal to or less than 20 mm. If the difference between Z2 and Z3 exceeds 20 mm, SiO generated in the chamber 2 flows toward the carbon heater 4, thereby generating CO from the carbon heater 4. This is not preferable.

Subsequently, there will be described a method for fabricating a single crystal C using the single crystal pull-up device as described above.

In the process for melting a raw-material silicon, a raw-material silicon is charged into the crucible 3 at first and, further, the exhaust pump is driven to form the first exhaust flow path X1, the second exhaust flow path X2 and the third exhaust flow path X3 for Ar gas G, in the chamber 2. On the other hand, a heater control portion is activated to heat the carbon heater 4 for starting an operation for melting the raw-material silicon in the crucible 3.

During melting of the raw material before the start of pulling up, the heightwise position of the crucible is controlled by a control portion configured to control an ascend/descend portion, such that the distance size Y1 between the upper end of the graphite crucible 3b and the upper end of the carbon heater 4 is equal to or more than 5 mm but equal to or less than 95 mm.

Further, after the silicon melt M has been prepared, an operation for pulling up the single crystal is started. Until the completion of pulling up the single crystal since the start of pulling up, the heightwise position of the crucible is controlled, such that the exhaust cross-sectional area (the exhaust cross-sectional area orthogonal to gas flows) S1 of the gap (the inlet portion) X1a between the lower end of the radiant shield 11 and the surface of the melt M is smaller than the exhaust cross-sectional area S3 of the exhaust flow path X3 formed by the inner tube 5 and the outer tube 8.

Further, the heightwise position of the crucible is controlled, such that the exhaust cross-sectional area S1 is equal to or more than S1 = 2πr×Gap mm². Further, after the start of the operation for pulling up the single crystal, the distance size Y1 between the upper end of the graphite crucible 3b and the upper end of the carbon heater 4 is set to be equal to or more than 100 mm, along with the ascending of the crucible.

Until the completion of pulling up since the completion of melting of the raw material, the heightwise position of the crucible is controlled, such that the exhaust cross-sectional area S1b of the flow path between the radiant shield 11 and the upper end of the graphite crucible is larger than the cross-sectional area S1 of the inlet X1a of the exhaust flow path X1, as described above.

As described above, according to the embodiment of the present invention, during melting of the raw material before the start of pulling up, the heightwise position of the crucible is controlled, such that the distance size Y1 between the upper end of the graphite crucible 3b and the upper end of the carbon heater 4 is equal to or more than 5 mm but equal to or less than 95 mm, which inhibits SiO generated in the chamber from coming into contact with the graphite crucible and the heater, thereby suppressing the generation of CO. Further, this can suppress back diffusion of CO generated from the graphite crucible and the heater, which is return of such CO to the melt, since it is possible to alleviate the influences of advections and diffusions thereof due to the inert gas.

Further, until the completion of pulling up of the silicon single crystal since when the raw material has been molten, the position of the crucible is controlled, such that the exhaust cross-sectional area of the gap between the lower end of the radiant shield and the surface of the melt, in the first exhaust flow path, is smaller than the exhaust cross-sectional area of the third exhaust flow path formed by the inner tube and the outer tube, which can realize smooth exhaust flows and, furthermore, can suppress clogging. Namely, it is possible to alleviate the influences of advections and diffusions due to the inert gas, which can suppress back diffusion, which is return of CO generated from the graphite crucible and the heater to the melt.

Accordingly, with the silicon single crystal fabrication device according to the present invention, it is possible to stably provide high-quality silicon single crystals with lower carbon concentrations.

### Examples

The single crystal pull-up device and the single crystal fabrication method according to the present invention will be further described with reference to Examples. In the present Examples, experiments were actually conducted using a single crystal pull-up device having the structure described in the aforementioned embodiment to confirm effects thereof.

### (Example 1)

During melting of the raw material before the start of pulling up of a silicon single crystal, the position of the upper end of the graphite crucible was controlled to be 5 mm above the upper end of the heater, and at this time, the internal pressure in the chamber was set to be 2000 Pa (15 Torr), and the flow rate of Ar gas introduced into the chamber was set to be 140 L/min. Further, until the completion of pulling up of the silicon single crystal since when the raw material has been molten, the exhaust cross-sectional area S1 of the gap between the lower end of the radiant shield and the surface of the melt, in the first exhaust flow path, was smaller than the exhaust cross-sectional area S3 of the third exhaust flow path formed by the inner tube and the outer tube.

Further, until the completion of pulling up of the silicon single crystal since the start of the pulling up of the silicon single crystal, the position of the upper end of the graphite crucible was controlled, such that the smallest cross-sectional area S1b out of the cross-sectional area of the flow path formed by the radiant shield and the upper end of the graphite crucible was an area equal to or more than the exhaust cross-sectional area S1 of the gap between the lower end of the radiant shield and the surface of the melt. Table 1 illustrates conditions of the experiments. Further, conditions of pulling up of the single crystal other than the conditions represented in Table 1 were the same as ordinary-used conditions and, also, were the same conditions in Examples 2 to 6 and Comparative Examples 1 to 4.

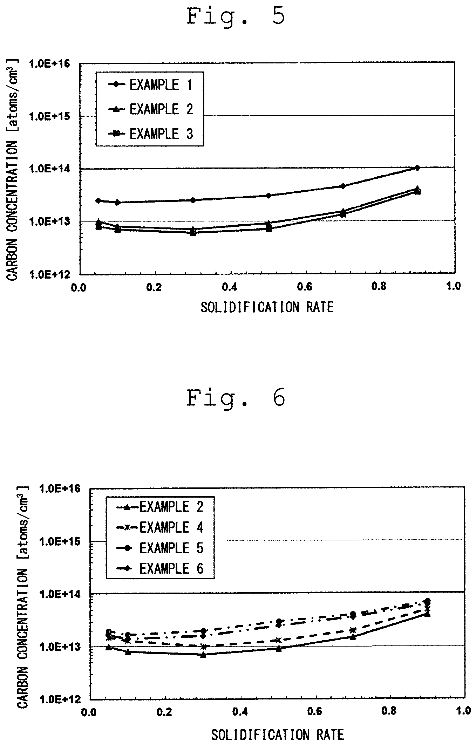

Further, the carbon concentration of the resultant silicon single crystal was determined. In the determination of the carbon concentration, a photo luminescence (PL) method was utilized (refer to S. Nakagawa, K. Kashima, M. Tajima, Proceedings of the Forum on the Science and Technology of Silicon Materials 2010(2010) 326). FIG. 5 represents the result.

### (Example 2)

An experiment was conducted, under the same conditions as those of Example 1, as represented in Table 1, except that the position of the upper end of the graphite crucible was controlled to be 50 mm above the upper end of the heater, during melting of the raw material before the start of pulling up of a silicon single crystal. Further, the carbon concentration of the resultant silicon single crystal was determined. FIG. 5 represents the result.

### (Example 3)

An experiment was conducted, under the same conditions as those of Example 1, as represented in Table 1, except that the position of the upper end of the graphite crucible was controlled to be 95 mm above the upper end of the heater, during melting of the raw material before the start of pulling up of a silicon single crystal. Further, the carbon concentration of the resultant silicon single crystal was determined. FIG. 5 represents the result.

### (Example 4)

An experiment was conducted, under the same conditions as those of Example 2, as represented in Table 1, except that the flow rate of Ar gas introduced into the chamber was controlled to be 100 L/min, during melting of the raw material before the start of pulling up of a silicon single crystal. Further, the carbon concentration of the resultant silicon single crystal was determined. FIG. 6 represents the result.

### (Example 5)

An experiment was conducted, under the same conditions as those of Example 2, as represented in Table 1, except that the flow rate of Ar gas introduced into the chamber was controlled to be 55 L/min, during melting of the raw material before the start of pulling up of a silicon single crystal. Further, the carbon concentration of the resultant silicon single crystal was determined. FIG. 6 represents the result.

### (Example 6)

An experiment was conducted, under the same conditions as those of Example 2, as represented in Table 1, except that the internal pressure in the chamber was controlled to be 12666 Pa (95 Torr), during melting of the raw material before the start of pulling up of a silicon single crystal. Further, the carbon concentration of the resultant silicon single crystal was determined. FIG. 6 represents the result.

### (Comparative Example 1)

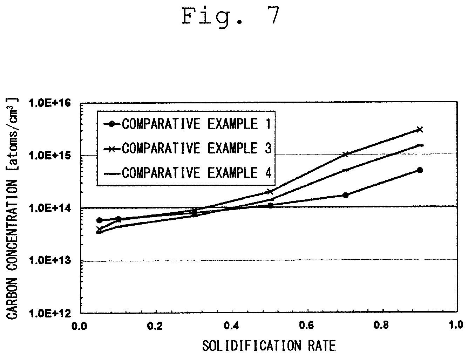

An experiment was conducted, under the same conditions as those of Example 1, as represented in Table 1, except that the position of the upper end of the graphite crucible was controlled to be 5 mm below the upper end of the heater, during melting of the raw material before the start of pulling up of a silicon single crystal. Further, the carbon concentration of the resultant silicon single crystal was determined. FIG. 7 represents the result.

### (Comparative Example 2)

An experiment was conducted, under the same conditions as those of Example 1, as represented in Table 1, except that the position of the upper end of the graphite crucible was controlled to be 105 mm above the upper end of the heater, during melting of the raw material before the start of pulling up of a silicon single crystal. Further, in the Comparative Example 2, the upper end of the quartz crucible was lowered in temperature, which caused SiO vaporized from the melt to adhere thereto, thereby degrading the yield. Therefore, it was impossible to conduct determination of the carbon concentration.

### (Comparative Example 3)

An experiment was conducted, under the same conditions as those of Example 1, as represented in Table 1, except that the position of the crucible was controlled, such that the exhaust cross-sectional area S1 of the gap between the lower end of the radiant shield and the surface of the melt, in the first exhaust flow path, was equal to or more than the exhaust cross-sectional area S3 of the third exhaust flow path X3 formed by the inner tube and the outer tube, during melting of the raw material before the start of pulling up of a silicon single crystal. Further, the carbon concentration of the resultant silicon single crystal was determined. FIG. 7 represents the result.

### (Comparative Example 4)

An experiment was conducted, under the same conditions as those of Example 1, as represented in Table 1, except that the position of the upper end of the graphite crucible was controlled to be 95 mm above the upper end of the heater, during melting of the raw material before the start of pulling up of a silicon single crystal and, also, such that the exhaust cross-sectional area S1 of the gap between the lower end of the radiant shield and the surface of the melt in the first exhaust flow path was equal to or more than the exhaust cross-sectional area S3 of the third exhaust flow path X3 formed by the inner tube and the outer tube until the completion of pulling up of the silicon single crystal since when the raw material had been molten. Further, the carbon concentration of the resultant silicon single crystal was determined. FIG. 7 represents the result.

**[Table 1]**

| No. | During melting of raw material before start of pulling up of silicon single crystal | | | Until completion of pulling up of silicon single crystal since completion of melting of raw material | Until completion of pulling up of silicon single crystal since start of pulling up of silicon single crystal |
|---|---|---|---|---|---|
| | Position of upper end of graphite crucible [mm] | Ar flow rate [L/min] | Internal pressure in furnace [Torr] | Exhaust cross-sectional area [mm²] | Exhaust cross-sectional area [mm²] |
| Example 1 | 5 mm above heater upper end | 140 | 2000 Pa (15 Torr) | S1<S3 | S1≤S1b |
| Example 2 | 50 mm above heater upper end | 140 | 2000 Pa (15 Torr) | S1<S3 | S1≤S1b |
| Example 3 | 95 mm above heater upper end | 140 | 2000 Pa (15 Torr) | S1<S3 | S1≤S1b |
| Example 4 | 50 mm above heater upper end | 100 | 2000 Pa (15 Torr) | S1<S3 | S1≤S1b |
| Example 5 | 50 mm above heater upper end | 55 | 2000 Pa (15 Torr) | S1<S3 | S1≤S1b |
| Example 6 | 50 mm above heater upper end | 140 | 12666 Pa (95 Torr) | S1<S3 | S1≤S1b |
| Comparative Example 1 | 5 mm above heater upper end | 140 | 2000 Pa (15 Torr) | S1<S3 | S1≤S1b |
| Comparative Example 2 | 105 mm above heater upper end | 140 | 2000 Pa (15 Torr) | S1<S3 | S1≤S1b |
| Comparative Example 3 | 5 mm above heater upper end | 140 | 2000 Pa (15 Torr) | S1≥S3 | S1≤S1b |
| Comparative Example 4 | 95 mm above heater upper end | 140 | 2000 Pa (15 Torr) | S1≥S3 | S1≤S1b |

The crystals obtained from Examples 1 to 3 were silicon single crystals with lower carbon concentrations of 1.0×10¹⁴ atoms/cm³ or less, in their crystal straight body portions with solidification rates of up to 90%, as illustrated in FIG. 5. Further, any of these crystals had lower carbon concentrations when the solidification rate was 10%, and exhibited slight reduction in carbon concentration after when the solidification rate was 10%. It is considered that this was because the generation of CO was suppressed and, furthermore, CO vaporized from the melt was smoothly exhausted to the outside of the furnace, during the melting of the raw material and during the pulling up.

Further, as illustrated in FIG. 6, the crystals resulted from Examples 4 to 6 were silicon single crystals with carbon concentrations of 1.0×10¹⁴ atoms/cm³ or less, which were lower carbon concentrations, at their crystal straight body portions with solidification rates of up to 90%.

On the other hand, as illustrated in FIG. 7, in the Comparative Examples 1, 3 and 4, the crystal body portions with solidification rates of up to 90% had carbon concentrations exceeding 1.0×10¹⁴ atoms/cm³, which made it impossible to provide a silicon single crystal with a targeted lower carbon concentration. Further, in the Comparative Example 2, the upper end of the quartz crucible was lowered in temperature, which caused SiO vaporized from the melt to adhere thereto, thereby degrading the yield.

## Claims

1. A silicon single crystal fabrication method using a silicon single crystal fabrication device (1), the silicon single crystal fabrication device (1) comprising:
a cylindrical-shaped chamber (2) having a supply port (2a) for supplying an inert gas thereto;
a crucible (3) provided in the chamber (2), the crucible (3) comprising a quartz-glass crucible (3a) at its inner side and a graphite crucible (3b) at its outer side;
an ascend/descend portion configured to ascend/descend a height of the crucible (3);
a control portion configured to control the ascend/descend portion;
a carbon heater (4) for melting a raw-material silicon charged in the crucible (3);
an inner tube (5) provided around an outer periphery of the carbon heater (4);
an outer tube (8) provided around an outer periphery of the inner tube (5);
a first heat-reserving plate (6) extending inward at an upper end portion of the inner tube (5);
a second heat-reserving plate (9) extending inward at an upper end portion of the outer tube (8);
a radiant shield (11) which is provided above and near the crucible (3) and is provided, at its upper and lower portions, with an opening surrounding a periphery of a silicon single crystal; and
an exhaust flow path formed by a first exhaust flow path (X1) formed by the radiant shield (11) and an inner peripheral surface of the crucible (3), a second exhaust flow path (X2) formed by the first heat-reserving plate (6) and the second heat-reserving plate (9), and a third exhaust flow path (X3) formed by the inner tube (5) and the outer tube (8),
wherein
a position of an upper end of the graphite crucible (3b) is controlled to be equal to or more than 5 mm but equal to or less than 95 mm above an upper end of the heater (4), during melting of the raw material before start of pulling up of the silicon single crystal, and
a position of the crucible is controlled, such that an exhaust cross-sectional area (S1) of a gap between a lower end of the radiant shield (11) and a surface of the melt, in the first exhaust flow path (X1), is smaller than an exhaust cross-sectional area (S3) of the third exhaust flow path (X3) formed by the inner tube (5) and the outer tube (8), until completion of pulling up of the silicon single crystal since completion of the melting of the raw material.

2. The silicon single crystal fabrication method according to Claim 1, wherein
until the completion of pulling up of the single crystal since the start of the pulling up of the silicon single crystal,
the position of the upper end of the graphite crucible (3b) is controlled, such that a smallest cross-sectional area, out of a cross-sectional area of the flow path formed by the radiant shield (11) and the upper end of the graphite crucible (3b), has an area equal to or larger than the exhaust cross-sectional area (S1) of the gap between the lower end of the radiant shield (11) and the surface of the melt.

3. The silicon single crystal fabrication method according to Claim 1 or 2, wherein
an exhaust cross-sectional area (S2) of the second exhaust flow path (X2) formed by the first heat-reserving plate (6) and the second heat-reserving plate (9) is made larger than an exhaust cross-sectional area (S3) of the third exhaust flow path (X3) formed by the inner tube (5) and the outer tube (8).

4. The silicon single crystal fabrication method according to any one of Claims 1 to 3, wherein
a heat insulator (10) is provided on an outer periphery of the outer tube (8), and
the inner tube (5) is formed to be a double tube, and a heat insulator (7) is provided in a space between tubes of the double tube.

## Patentansprüche

1. Siliziumeinkristallfertigungsverfahren unter Verwendung einer Siliziumeinkristallfertigungsvorrichtung (1), wobei die Siliziumeinkristallfertigungsvorrichtung (1) umfasst:
eine zylinderförmige Kammer (2) mit einem Einbringanschluss (2a) zum Einbringen eines Inertgases in diese;
einen in der Kammer (2) bereitgestellten Tiegel (3), wobei der Tiegel (3) auf seiner Innenseite einen Quarzglastiegel (3a) und auf seiner Außenseite einen Graphittiegel (3b) umfasst;
einen Höhenverstellabschnitt, der konfiguriert ist, eine Höhe des Tiegels (3) nach oben/unten zu verstellen;
einen Reglerabschnitt, der konfiguriert ist, den Höhenverstellabschnitt zu regeln;
ein Kohlenstoffheizelement (4) zum Schmelzen eines in den Tiegel (3) geladenen Rohmaterialsiliziums;
eine Innenröhre (5), die um einen Außenumfang des Kohlenstoffheizelements (4) herum bereitgestellt ist;
eine Außenröhre (8), die um einen Außenumfang der Innenröhre (5) herum bereitgestellt ist;
eine erste wärmespeichernde Platte (6), die sich an einem oberen Endabschnitt der Innenröhre (5) nach innen erstreckt;
eine zweite wärmespeichernde Platte (9), die sich an einem oberen Endabschnitt der Außenröhre (8) nach innen erstreckt;
einen Strahlenschutz (11), der oberhalb und in der Nähe des Tiegels (3) bereitgestellt und in seinem oberen und unteren Abschnitt mit einer Öffnung versehen ist, die einen Umfang eines Siliziumeinkristalls umgibt; und
einen Abluftströmungsweg, der durch einen ersten Abluftströmungsweg (X1), der durch den Strahlenschutz (11) und eine innere Umfangsoberfläche des Tiegels (3) gebildet ist, einen zweiten Abluftströmungsweg (X2), der durch die erste wärmespeichernde Platte (6) und die zweite wärmespeichernde Platte (9) gebildet ist, und einen dritten Abluftströmungsweg (X3) gebildet ist, der durch die Innenröhre (5) und die Außenröhre (8) gebildet ist,
wobei
eine Position eines oberen Endes des Graphittiegels (3b) so geregelt ist, dass sie sich während des Schmelzens des Rohmaterials vor dem Beginn des Hochziehens des Siliziumeinkristalls genau 5 mm oder mehr, aber genau 95 mm oder weniger oberhalb eines oberen Endes des Heizelements (4) befindet, und
eine Position des Tiegels so geregelt ist, dass eine Abluftquerschnittsfläche (S1) eines Spalts zwischen einem unteren Ende des Strahlenschutzes (11) und einer Oberfläche der Schmelze in dem ersten Abluftströmungsweg (X1) vom Abschluss des Schmelzens des Rohmaterials bis zum Abschluss des Hochziehens des Siliziumeinkristalls geringer ist als eine Abluftquerschnittsfläche (S3) des dritten Abluftströmungsweges (X3), der durch die Innenröhre (5) und die Außenröhre (8) gebildet ist.

2. Siliziumeinkristallfertigungsverfahren nach Anspruch 1, wobei
vom Beginn des Hochziehens des Siliziumeinkristalls bis zum Abschluss des Hochziehens des Siliziumeinkristalls
die Position des oberen Endes des Graphittiegels (3b) so geregelt ist, dass eine kleinste Querschnittsfläche aus einer Querschnittsfläche des durch den Strahlenschutz (11) und das obere Ende des Graphittiegels (3b) gebildeten Strömungswegs eine Fläche besitzt, die größer oder gleich der Abluftquerschnittsfläche (S1) des Spalts zwischen dem unteren Ende des Strahlenschutzes (11) und der Oberfläche der Schmelze ist.

3. Siliziumeinkristallfertigungsverfahren nach Anspruch 1 oder 2, wobei
eine Abluftquerschnittsfläche (S2) des zweiten Abluftströmungsweges (X2), der durch die erste wärmespeichernde Platte (6) und die zweite wärmespeichernde Platte (9) gebildet ist, größer hergestellt ist als eine Abluftquerschnittsfläche (S3) des dritten Abluftströmungsweges (X3), der durch die Innenröhre (5) und die Außenröhre (8) gebildet ist.

4. Siliziumeinkristallfertigungsverfahren nach einem der Ansprüche 1 bis 3, wobei
ein Wärmeisolator (10) auf einem Außenumfang der Außenröhre (8) bereitgestellt ist und
die Innenröhre (5) als Doppelröhre ausgebildet ist und ein Wärmeisolator (7) in einem Raum zwischen den Röhren der Doppelröhre bereitgestellt ist.

## Revendications

1. Procédé de fabrication d'un monocristal de silicium en utilisant un dispositif de fabrication de monocristal de silicium (1), le dispositif de fabrication de monocristal de silicium (1) comprenant:
une chambre de configuration cylindrique (2) possédant un orifice d'alimentation (2a) pour l'alimentation d'un gaz inerte ;
un creuset (3) prévu dans la chambre (2), le creuset (3) comprenant un creuset en verre de silice (3a) sur son côté interne et un creuset en graphite (3b) sur son côté externe ;
une portion d'élévation/descente configurée pour élever/descendre une hauteur du creuset (3) ;
une portion de commande configurée pour commander la portion d'élévation/descente ;
un chauffage au carbone (4) pour la mise en fusion d'un silicium à titre de matière de départ chargé dans le creuset (3) ;
un tube interne (5) prévu autour d'une périphérie externe du chauffage au carbone (4) ;
un tube externe (8) prévu autour d'une périphérie externe du tube interne (5) ;
une première plaque de conservation de chaleur (6) s'étendant vers l'intérieur à une portion terminale supérieure du tube interne (5) ;
une seconde plaque de conservation de chaleur (9) s'étendant vers l'intérieur à une portion terminale supérieure du tube externe (8) ;
un écran contre la chaleur rayonnante (11) qui est prévu au-dessus et à proximité du creuset (3) et qui est muni, à ses portions supérieure et inférieure, d'une ouverture entourant une périphérie d'un monocristal de silicium ; et
une voie d'écoulement de sortie formée par une première voie d'écoulement de sortie (X1) formée par l'écran contre la chaleur rayonnante (11) et une surface périphérique interne du creuset (3), une deuxième voie d'écoulement de sortie (X2) formée par la première plaque de conservation de chaleur (6) et la seconde plaque de conservation de chaleur (9), et une troisième voie d'écoulement de sortie (X3) formée par le tube interne (5) et le tube externe (8),
dans lequel
une position d'une extrémité supérieure du creuset en graphite (3b) est commandée pour être égale à ou supérieure à 5 mm, mais égale à ou inférieure à 95 mm au-dessus d'une extrémité supérieure du chauffage (4), au cours de la mise en fusion de la matière de départ avant le démarrage du tirage vers le haut du monocristal de silicium, et
une position du creuset est commandée d'une manière telle qu'une superficie de sortie en section transversale (S1) d'un espace libre entre une extrémité inférieure de l'écran contre la chaleur rayonnante (11) et une surface de la masse fondue, dans la première voie d'écoulement de sortie (X1), est inférieure à une superficie de sortie en section transversale (S3) de la troisième voie d'écoulement de sortie (X3) formée par le tube interne (5) et le tube externe (8), jusqu'à l'achèvement du tirage vers le haut du monocristal de silicium à partir de l'achèvement de la mise en fusion de la matière de départ.

2. Procédé de fabrication d'un monocristal de silicium selon la revendication 1, dans lequel :
jusqu'à l'achèvement du tirage vers le haut du monocristal à partir du début du tirage vers le haut du monocristal de silicium,
la position de l'extrémité supérieure du creuset en graphite (3b) est commandée d'une manière telle qu'une superficie en section transversale la plus petite, hors d'une superficie en section transversale de la voie d'écoulement formée par l'écran contre la chaleur rayonnante (11) et l'extrémité supérieure du creuset en graphite (3b), possède une superficie égale ou supérieure à la superficie de sortie en section transversale (S1) de l'espace libre entre l'extrémité inférieure de l'écran contre la chaleur rayonnante (11) et la surface de la masse fondue.

3. Procédé de fabrication d'un monocristal de silicium selon la revendication 1 ou 2 dans lequel :
une superficie de sortie en section transversale (S2) de la deuxième voie d'écoulement de sortie (X2) formée par la première plaque de conservation de chaleur (6) et la seconde plaque de conservation de chaleur (9) est réalisée pour être supérieure à une superficie de sortie en section transversale (S3) de la troisième voie d'écoulement de sortie (X3) formée par le tube interne (5) et le tube externe (8).

4. Procédé de fabrication d'un monocristal de silicium selon l'une quelconque des revendications 1 à 3, dans lequel :
un isolant thermique (10) est prévu sur une périphérie externe du tube externe (8) ; et
le tube interne (5) est conçu pour former un tube double, et un isolant thermique (7) est prévu dans un espace entre les tubes du tube double.
